## Europäisches Patentamt
## European Patent Office
## Office européen des brevets

(11) Veröffentlichungsnummer: **0 081 770**
**B1**

(12) **EUROPÄISCHE PATENTSCHRIFT**

(45) Veröffentlichungstag der Patentschrift:
**13.01.88**

(21) Anmeldenummer: **82111197.8**

(22) Anmeldetag: **03.12.82**

(51) Int. Cl.⁴: **C 25 D 5/02,** C 25 D 17/00,
C 09 J 7/00

(54) Abdeckband für galvanische Prozesse.

(30) Priorität: **12.12.81 DE 3149282**
**20.03.82 DE 3210288**

(43) Veröffentlichungstag der Anmeldung:
**22.06.83 Patentblatt 83/25**

(45) Bekanntmachung des Hinweises auf die Patenterteilung:
**13.01.88 Patentblatt 88/2**

(84) Benannte Vertragsstaaten:
**BE DE FR GB IT NL SE**

(56) Entgegenhaltungen:
**AU-B-65 074**
**GB-A-1 328 347**
**US-A-2 678 284**
**US-A-3 165 421**

**CHEMICAL ABSTRACTS, Band 95, Nr. 14, August
1981, Seite 539, Nr. 69944q, Columbus, Ohio, US
CHEMICAL ABSTRACTS, Band 95, Nr. 5, September
1981, Seite 481, Nr. 88220s, Columbus, Ohio, US**

(73) Patentinhaber: **Beiersdorf Aktiengesellschaft,
Unnastrasse 48, D-2000 Hamburg 20 (DE)**

(72) Erfinder: **Grah, Klaus, Klingenstrasse 70a, D-5650
Solingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

In der Galvanotechnik ist es Stand der Technik bei zu galvanisierenden Gegenständen, z. B. Leiterplatten, vorbestimmte Oberfläche, von Niederschlägen freizuhalten, indem diese durch selbstklebende Abdeckbänder abgedeckt werden. Diese Bänder bestehen aus einem Papier- oder Folienträger, der mit einer elastische, Selbstklebemasse ausgerüstet ist.

Aufgrund einer gewissen Starrheit des Trägers und nur geringer Verformbarkeit der Masse stößt eine einwandfreie Abdeckung dann auf Schwierigkeiten, wenn der Abstand zwischen zwei Erhebungen (z. B. Leiterbahnen) nur relativ gering ist und/oder die Erhebungen relativ hoch sind. Die in diesem Fall entstehenden Hohlräume können Flüssigkeiten aufnehmen, die den zu galvanisierenden Gegenstand nachteilig beeinflussen.

Ein weiterer Nachteil ist, daß bei diesen Verklebungen zwischen erhabenen Flächen und dem Normalniveau die Klebung unter Spannung (elastische Verformung) steht. Dieses Rückstellvermögen bewirkt besonders bei höherer Temperaturbelastung der Klebfuge, z. B. durch höhere Badtemperatur, eine Minderung der Adhäsion des Haftklebers und damit ein teilweises Ablösen der Abdeckung.

Der Effekt bedingt wie oben ein Einwandern von Badflüssigkeit mit ihren negativen Folgen.

Ein weiterer Nachteil ist die eingeschränkte Korrekturfähigkeit eines Seblstklebebandes.

Ziel der Erfindung ist es, ein Abdeckband zu verwenden, das eine vollkommene Abdeckung des abzudeckenden Teiles eines zu galvanisierenden Gegenstandes gewährleistet, und zwar unabhängig von der Höhe der Erhebungen und/oder den Abständen der Erhebungen voneinander, und bei dem ferner beim Verklebungsprozeß keine höheren Spannungen und sonst beim Einwirken höherer Temperaturen keine Abhebungen auftreten.

Überraschenderweise läßt sich die Aufgabe mit einem Papier- oder Folien-Abdeckband beschichtet mit einer Klebstoffmasse auf Basis eines Plastomers, eines Hartharzes und eines Weichmachers lösen, wie in den Ansprüchen 1 bis 3 definiert.

Die Masse ist bei Raumtemperatur nicht selbstklebend. Daher kann das Band zur Korrektur leicht verschoben werden. Die Verklebung erfolgt durch Wärmeaktivierung bei etwa 100 - 140°C. In etwa diesem Temperaturbereich schmilzt das Harz und erweicht das Plastomer. Die Klebstoffmasse kann sich so spannungsfrei den Erhebungen bzw. Vertiefungen des Untergrundes ohne Hohlräume anpassen. Dabei sorgt der Weichmacheranteil dafür, daß das System auch bei 20-65° spannungsfrei und ohne Rückstellkräfte bleibt.

Für die Auswahl der Basisprodukte ist als Vorbedingung erforderlich, daß sie nicht reaktiv sind, nicht korrosiv auf Leiterplatten einwirken, nicht wasserlöslich sind, nicht in Wechselwirkung mit den Galvanobändern treten, sich nach der Wärmeaktivierung und dem Galvanoprozeß mit Lösungsmitteln entfernen lassen, und eventuelle Rückstände keinen Effekt auf den Lötprozeß haben.

Die Plastomere sind für die innere Festigkeit der Klebstoffschicht verantwortlich. Geeignet ist ein Polyvinylacetat.

Das Hartharz hat die Aufgabe, im Siegelbereich zu schmelzen, mit dem Plastomer eine verträgliche Lösung zu bilden, die zu verklebenden Teile zunetzen, (d.h. aufgrund der Oberflächenspannung in alle Hohlräume und Kapillaren hinein zu kriechen und beim Abkühlen eine hinreichende Haftung zu geben). Höhere Verbundfestigkeiten, wie sonst bei Klebstoffen üblich oder angestrebt, sind hier nicht erforderlich. Geeignet ist Kolophonium und seine Derivate mit einem Erweichungsbereich von etwa 60 - 110°C.

Der Weichmacher dient zur Flexibilisierung der eventuell spröden Elastomer-Harz-Masse, begünstigt das Fließverhalten im Siegelbereich und verhindert durch Minimierung von Spannungsspitzen die partielle Abhebung der Abdeckschicht.

Geeignete Weichmacher sind Phthalate und Adipate.

Die Masse enthält 10 - 60 Gew.-% Plastomer und 70 - 30 Gew.-% Hartharz, und 20 - 10 Gew.-% Weichmacher.

## Beispiel 1

Abdeckband, Papier-Träger, 100 µm, beschichtet mit 100 g/m² einer Masse bestehend aus 40 Gew.-% Polyvinylacetat, 40 Gew.-% Kolophonium und 20 Gew.-% polymerer Phathalsäureester. Das Abdeckband wird bei 100°C auf eine Leiterplatte gesiegelt und zur Kontrolle bei 60°C in ein Ätzbad eingebracht. Wegen des leichten Durchdringungsvermögens für Lösungsmittel braucht der Papierträger nicht gesondert abgezogen zu werden, vielmehr wird er zusammen mit der Klebmasse mit Lösungsmittel abgewaschen. Ergebnis: keine Unterwanderungen.

## Patentansprüche

1. Verwendung eines Abdeckbandes bei galvanischen Prozessen, dadurch gekennzeichnet, daß man ein Papier- oder Folien-Abdeckband verwendet, welches mit einer Klebstoffmasse beschichtet ist, die

a) 10 - 60 Gew.-% eines Polyvinylacetat Plastomers,

b) 70 - 30 Gew.-% Kolophonium oder seine Derivate mit einem Erweichungsbereich von etwa 60 - 110°C als Hartharz, und

c) 20 - 10 Gew.-% eines Weichmachers enthält.

2. Verwendung eines Abdeckbandes gemäß Anspruch 1, dadurch gekennzeichnet, daß die Klebstoffmasse etwa 40 gew.-% des Plastomers und etwa 40 Gew.-% des Hartharzes enthält.

3. Verwendung eines Abdeckbandes gemäß Anspruch 1, dadurch gekennzeichnet, daß die Klebstoffmasse ein Phthalat oder Adipat als Weichmacher enthält.

## Claims

1. Use of a masking strip in electroplating processes, characterized in that a paper or film strip is used which is coated with an adhesive composition whith contains:

a) 10-60 % by weight of a polyvinyl acetate plastomer,

b) 70-30 % by weight of colophony or derivatives thereof, having a softening point of about 60-110° C, as a hard resin and

c) 20-10 % by weight of a plasticizer.

2. Use of a masking strip according to Claim 1, characterized in that the adhesive composition contains about 40 % by weight of the plastomer and about 40 % by weight of the hard resin.

3. Use of a masking strip according to Claim 1, characterized in that the adhesive composition contains a phthalate or an adipate as the plasticizer.

## Revendications

1. Utilisation d'une bande de masquage dans des procédés galvanoplastiques, caractérisé en ce qu'on utilise une bande de masquage en papier ou en pellicule qui est enduite d'une matière adhésive qui comprend:

a) 10 à 60 % en poids d'un acétate de polyvinyle plastomère,

b) 70 à 30 % en poids de colophane ou de ses dérivés présentant un intervalle de ramollissement d'environ 60 à 110°C à titre de résine dure, et

c) 20 à 10 % en poids d'un plastifiant.

2. Utilisation d'une bande de masquage suivant la revendication 1, caractérisée en ce que la matière adhésive contient environ 40 % en poids du plastomère et environ 40 % en poids de la résine dure.

3. Utilisation d'une bande de masquage suivant la revendication 1, caractérisée en ce que la matière adhésive contient un phtalate ou un adipate à titre de plastifiant.